Europäisches Patentamt

European Patent Office

Office européen des brevets

(11) Publication number: **0 459 457 A2**

# EUROPEAN PATENT APPLICATION

(21) Application number: **91108817.7**

(22) Date of filing: **29.05.91**

(51) Int. Cl.⁵: **H03K 19/003**

(30) Priority: **29.05.90 JP 137204/90**

(43) Date of publication of application:
**04.12.91 Bulletin 91/49**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken(JP)**

Applicant: **TOSHIBA MICRO-ELECTRONICS**
**CORPORATION**
**25-1, Ekimaehoncho**
**Kawasaki-ku Kawasaki-shi(JP)**

(72) Inventor: **Kimura, Masahiro**
**1-21-10-318, Matsumicho, Kanagawa-ku**
**Yokohama-shi, Kanagawa-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Output driver.**

(57) Disclosed is an output driver which comprises a CMOS inverter as a logical portion (1) for providing a high voltage and a low voltage, a first diode (DP2) connected between the CMOS inverter (1) and the high voltage power source in forward direction observed from the high voltage power source (VDD), a second diode (DN2) connected between the CMOS inverter (1) and the low voltage power source (groung) in forward direction observed from the CMOS inverter (1), a first conductivity type field effect transistor (P3) connected to the first diode (DP2) in parallel, a second conductivity type field effect transistor (N3) connected to the second diode (DN2) in parallel, a first inverter (2P) for controlling on and off states of the first conductivity type FET (P3) connected to the first inverter (2P), and a second inverter (2N) for controlling on and off states of the second conductivity type FET (N3) connected to the second inverter (2N).

**FIG.5**

## BACKGROUND OF THE INVENTION

### Field of the Invention

This invention relates to an output driver which is capable of reducing the effect of inductance of the output side thereof.

### Description of the Prior Art

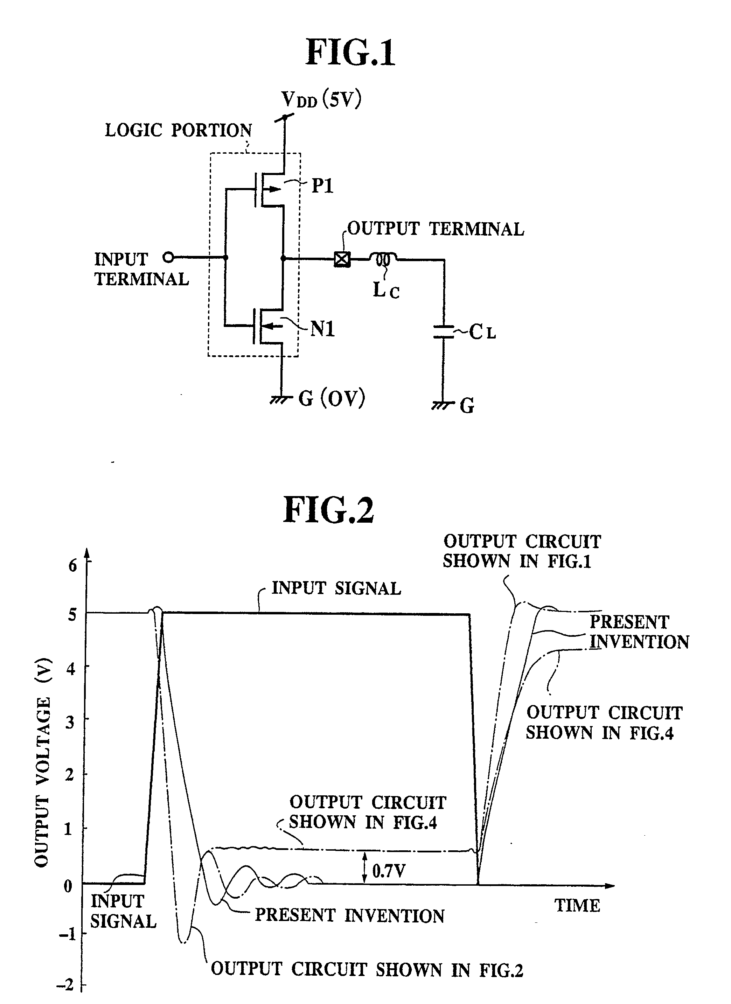

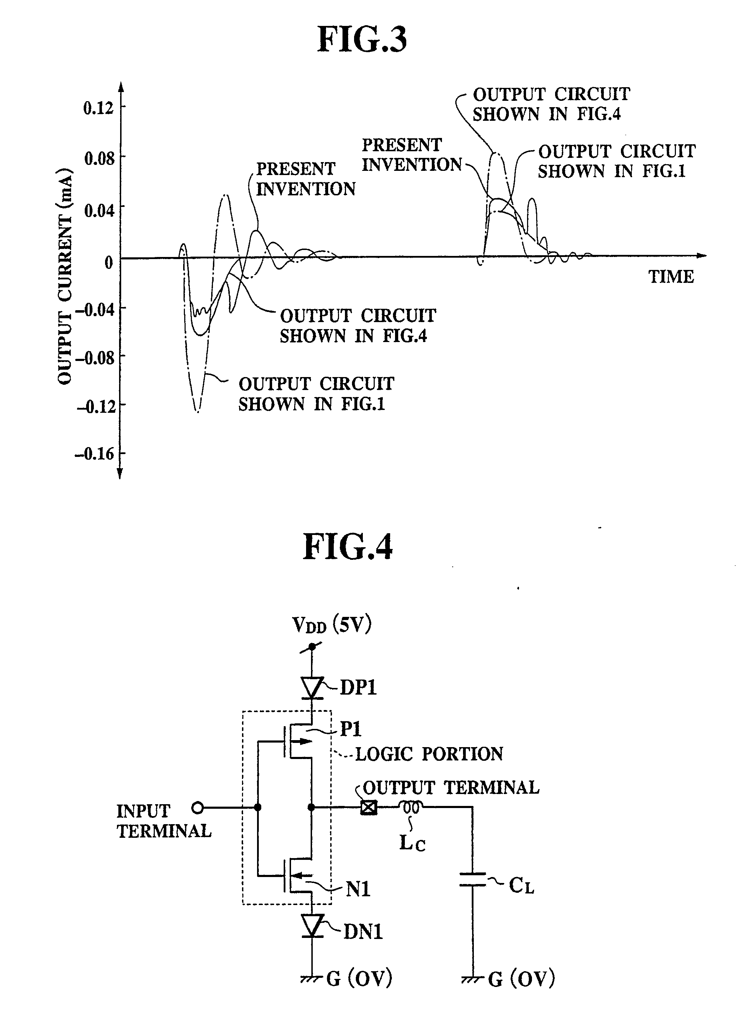

An example of a circuit with a buffer circuit or output stage is given in Fig. 1. Conventionally, this circuit is frequently used as an output circuit or an output driver.

Fig. 1 is a diagram showing the circuit configuration of an output driver formed from a CMOS.

This output driver comprises a P-channel FET (Field Effect Transistor) P1 connected in series between a power source VDD and ground (G), and an N-channel FETN1. A gate terminal connected in common as an input terminal, and a series-connected output terminals OUT are also provided.

In practice, when this type of output driver is incorporated in various types of circuits, devices, and the like, an incidental inductance (Lc) component included in the wiring is added, as shown in Fig. 1. When this type of inductance component is added to the output terminal OUT, a reverse electromotive force represented as - L di/dt is produced by an inductance component L and a transition current i during an output potential level transition caused by a level change in an input signal. As a result, the output potential as shown by the dotted line in Fig. 2, or the output current as shown by the dotted line in Fig. 3, follow the main transition and a transient phenomenon (ringing) is produced in which the sequence of a final constant value oscillates in a damped manner.

In this type of ringing, when the overshoot of the output potential is large with respect to the final constant value, there is concern that the threshold level of the next circuit will be exceeded, which can cause faulty operation. The output current could also become excessive, as shown in Fig. 3, causing an increase in power consumption.

Accordingly, a circuit configuration as shown in Fig. 4 has been proposed to eliminate this type of problem.

The main features of the circuit configuration shown in Fig. 4 are as follows. In comparison with the circuit configuration shown in Fig. 1, a diode DP1 is connected in series between the power source VDD and the FETP1, and a diode DN1 is connected in series between the FETN1 and ground.

In a configuration of this type, during the transition of the output potential the normal flow is from the output circuit OUT to the power source VDD, and from ground to the output terminal OUT, so that reverse flow is prevented. In addition, any excess current is reduced. because of this, the ringing noise from the output potential can be restrained as shown by the dotted line in Fig. 2.

However, in this type of configuration, as shown in Fig. 2, the output potential is reduced from the high level of the power source potential VDD to a built-in voltage (VF) of a diode DN1 only, and the low level is increased from ground potential to the built-in voltage only.

For this reason, when the built-in voltage VF of the diode is about 0.7 V, the low level of the output potential cannot fall below 0.7 V, as shown in Fig. 2.

Accordingly, the output current cannot be set when the low level VOL of the output potential is 0.4 V, and it is impossible to have a direct interface with a circuit operating at the TTL level.

As can be understood from the foregoing explanation, with a conventional output driver as shown in Fig. 1, an excessive current flows during the transition of the output potential and there is concern that a comparatively large ringing noise will be produced which can cause an increase in power consumption and faulty operation.

With the conventional output driver shown in Fig. 4 the occurrence of the ringing noise can be eliminated but it is not possible to interface directly with the circuit when the operating level of a TTL device or the like is abnormal. The operating range of the output driver is therefore limited.

## SUMMARY OF THE INVENTION

An object of the present invention is to provide a output driver which is capable of reducing the effect of inductance component of the output side thereof.

To achieve the above object, the output driver according to the present invention comprises

a logical means for providing a high voltage and a low voltage one of which is selected in accordance with an input signal provided to the output driver, then provided from a high voltage power source or a low voltage power source,

a first diode connected between the logical means and the high voltage power source in forward direction observed from the high voltage power source,

a second diode connected between the logical means and the low voltage power source in forward direction observed from the logical portion,

a first conductivity type field effect transistor (FET) connected to the first diode in parallel,

a second conductivity type field effect transistor (FET) connected to the second diode in parallel,

a first delay control means for controlling on and off states of the first conductivity type FET connected to the first delay control means, and

a second delay control means for controlling on and off states of the second conductivity type FET connected to the second delay control means.

These and other objects, feature and advantages of the present invention will be more apparent from the following description of a preferred embodiment, taken in conjuction with the accompanying drawing.

BRIEF DESCRIPTION OF THE DRAWINGS

Fig. 1 is a diagram showing a circuit configuration of an conventional output driver;
Fig. 2 is a diagram showing changes of output potential voltages of a conventional output driver and a output driver of the present invention;
Fig. 3 is a diagram showing changes of output currents of a conventional output driver and a output driver of the present invention;
Fig. 4 is a diagram showing a circuit configuration of another conventional output driver; and

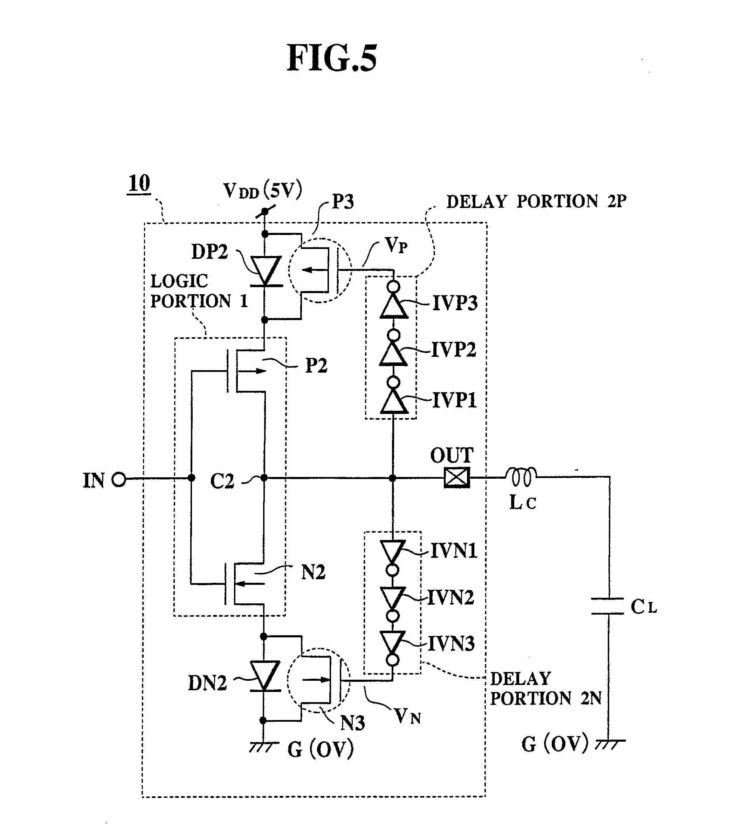

Fig. 5 is a diagram showing a circuit configuration of an output driver according to the present invention.

DETAILED DESCRIPTION OF THE EMBODIMENTS

An embodiment of the present invention will now be explained with reference to the drawings.

Fig. 5 is a view showing a circuit configuration for a n output driver relating to a first embodiment of the present invention.

As illustrated in Fig. 5, an output driver 10 comprises a logic portion 1 for outputting an output signal, which has a high potential or a low potential corresponding to an input signal provided to an input terminal IN, to an output terminal OUT; a pair of delay portion 2P, 2N for delaying the output signal from the output terminal OUT; a pair of diodes DP2, DN2 which have a rectification function; and a pair of FETs P3, N3 which provide bypass control for the diodes DP2, DN2.

The logic portion 1 is connected in series with the P-channel FETP2 and the N-channel FETN2, and comprises the gate terminals of the FETs P2, n2 as the input terminal IN and a connection point C2 as the output terminal OUT.

The source terminal of the FETP2 is connected to a power source VDD through the diode DP2 which is inserted in the forward direction in series with the source terminal of FETP2 from the power source VDD, and the P-channel FETP3 which is connected in parallel with the diode DP2. The source terminal of the FETN2 is connected to ground G through the diode DN2 which is inserted in the forward direction with respect to ground G, and the N-channel FETN3 which is connected in parallel with the diode DN2.

The delay portion 2P comprises three inverters IVP1, IVP2, and IVP3 connected in parallel, and the delay portion 2N comprises three inverters IVN1, IVN2, and IVN3 connected in parallel. The delay portions 2P, 2N delay for a preset time only output signals provided at the output terminal OUT and provide these signals to the respective corresponding gate terminals of FETP3, N3 for ON, OFF control of FETP3, N3 respectively.

In this type of configuration, when, for example, an input signal changes from low level to high level, the output signal changes from low level to high level. In such input signal transition state, first, with the input signal in the low level state, the output terminal OUT is in the high level state so that the gate potential (VN) of the FET3 is at low level and the FETN3 is in the OFF state.

When the input signal changes from this state to the high level and the threshold voltage of the FET2 is exceeded, the FETN2 changes ON state. As a result, the current flows from the output terminal OUT to ground G through the FETN2 and the diode DN2, and the output terminal OUT steadily changes from the high level state to the low level state.

In this type of state transition, when the potential of the output terminal OUT drops below the threshold voltage of the inverter IVN1, which is the initial stage of the delay circuit 2N, the inverter IVN1 commences the invention action. This results in the final stage inverters IVN2, IVN3 also being delayed in sequence and performing the inversion action, so that the gate potential (VN) of the FETN3, which is the output of the delay portion 2N, changes from low level to high level. Then, when the gate potential (VN) of the FETN3 exceeds the threshold voltage of the FETN3, the FETN3 changes to the ON state. As a result,the current flows from the output terminal OUT to ground G through the FETN2 and the FETN3.

With this type of state transition, after the potential of the output terminal OUT drops below the threshold voltage of the inverter IVN1, a predetermined time delay set at the delay portion 2N elapses and the FETN3 changes to the ON state.

Accordingly, in the interval from the commencement of the drop of the potential of the output terminal OUT from the high level to the low level until the FETN3 changes to the ON state, the potential of the output terminal OUT continues to drop so that when the FETN3 changes to the ON state, the potential of the output terminal OUT becomes almost equivalent to ground potential.

This is because the potential across the drain source (VDS) of the FETN2 and the FETN3 respectively is small, and the amount of change in the phenomenon of excess current flowing in the FETN2 and the FETN3 is small. Accordingly, a kick voltage (- L di/dt) produced from an incidental inductance component CL connected to the output terminal OUT is also small. As a result, through the FETN3 entering the ON state, even if a kick voltage is produced, the value is small. Therefore, the ringing noise is low.

In addition, through the FETN3 entering the ON state, the potential of the output terminal OUT drops further and becomes almost equivalent to ground potential G.

In the case where the output signal changes from the low level to the high level because of the change of the input signal from the high level to the low level, the polarities of the FETP2, P3, diode DP2, and delay portion 2P act as the reverse of the polarities of the respectively corresponding FETN2, N3, diode DN2, and delay portion 2N, and an excessive kick voltage i snot produced.

The potential of the output terminal OUT therefore reaches the potential VDD of the power source.

Accordingly, in changing the output signal level according to the change in level of the input signal, the output potential, as shown in Fig. 2, cannot cause a loud ringing noise such as occurs in a conventional configuration when the threshold voltage of an externally connected circuit is exceeded, and the power source potential, whether a high VDD or a low G, is obtained to correspond to the input signal. In addition, the output current, as shown in Fig. 3, can be extensively reduced in comparison with the output current of an output driver with a conventional configuration, as shown in Fig. 2. As a result, it is possible, for example, to set the output current (IOL) when the output potential (VOL) is 0.4 V at the low level of the output terminal, and therefore it is possible to have a direct interface with a TTL level device at the output driver 10.

Furthermore, the present invention is not limited to the above embodiment. For example, the logic portion 1 may also have a configuration such as that of a NAND gate or a tri-state inverter circuit or the like. In addition, the delay portion 2P, 2N may also be, for example, a time constant circuit or the like, with low resistance and capacity, or a circuit configuration with the function of delaying and inverting the output signal. The diodes DP2, DN2 can be, other than the usual diode with a P-N junction, a Schottky barrier diode or the like, or a unit with a rectification function.

Various modification will become possible for those skilled in the art after the teaching of the present disclosure without departing from scope thereof.

Various modification will become possible for those skilled in the art after the teaching of the present disclosure without departing from the scope thereof.

Reference signs in the claims are intended for better understanding and shall not limit the scope.

**Claims**

1. An output driver comprising:
   a logical means (1) for providing a high voltage and a low voltage one of which is selected in accordance with an input signal provided to the output driver (10), then provided from a high voltage power source or a low voltage power source,
   a first diode (DP2) connected between the logical means (1) and the high voltage power source in forward direction observed from the high voltage power source,
   a second diode (DN2) connected between the logical means (1) and the low voltage power source in forward direction observed from the logical portion (1),
   a first conductivity type field effect transistor (P3) connected to the first diode (DP2) in parallel,
   a second conductivity type field effect transistor (N3) connected to the second diode (DN2) in parallel,
   a first delay control means (2P) for controlling on and off states of the first conductivity type field effect transistor (P3) connected to the first delay control means (2P), and
   a second delay control means (2N) for controlling on and off states of the second conductivity type field effect transistor (N3) connected to the second delay control means (2N).

2. An output driver according to claim 1, wherein the logical means (1) comprises CMOS inverter.

3. An output driver according to claim 1, wherein the logical means (1) comprises a tri-state inverter.

4. An output driver according to claim 1, wherein the logical means (1) comprises a NAND gate.

5. An output driver according to claim 1, wherein the logical means (1) comprises a NOR gate.

6. An output driver according to claim 1, wherein each of the first and the second delay control means (2P and 2N) comprises odd number inverters which are connected in series.

7. An output driver according to claim 1, wherein each of the first and the second delay control means (2P and 2N) comprises three inverters which are connected in series.

8. An output driver according to claim 1, wherein each of the first and the second delay control means (2P and 2N) comprises a time constant RC circuit comprising a resistance and a capacity.

9. An output driver according to claim 1, wherein the each of the first and the second diodes (DP2 and DN2) comprises a Schottky barrier diode.

# FIG.1

# FIG.2

# FIG.3

# FIG.4

# FIG.5